# EUROPÄISCHE PATENTANMELDUNG

(11) **EP 4 178 112 A1**
(43) Veröffentlichungstag der Anmeldung: **10.05.2023**
(21) Anmeldenummer: 22200453.3
(22) Anmeldetag: 10.10.2022
(51) Int. Cl.: H03K 17/95

(54) **NÄHERUNGSSCHALTER UND VERFAHREN ZUM BETRIEB EINES NÄHERUNGSSCHALTERS**

(30) Priorität: 04.11.2021 DE 102021128706
(71) Anmelder: Turck Holding GmbH, 58553 Halver (DE)
(72) Erfinder: Wendler, Torsten, 08340 Schwarzenberg (DE)
(74) Vertreter: DTS Patent- und Rechtsanwälte Schnekenbühl und Partner mbB

(57) **Zusammenfassung**

Näherungsschalter mit einem Oszillator, der ein magnetisches Wechselfeld erzeugt und durch ein in den Erfassungsbereich eindringendes Target seinen Schwingungszustand ändert, einem Oszillatorverstärker und einem Temperatursensor zur Erfassung der Temperatur eines Elements des Näherungsschalters und/oder der Umgebung, wobei der Oszillationsverstärker steuer- und regelbar ausgebildeten ist und mindestens eine Verstärkerstufe aufweist. Hierbei ist der Oszillator auf Grundlage der vom dem Temperatursensor bestimmten Temperatur regel- und steuerbar, wobei die mindestens eine Verstärkerstufe des Oszillationsverstärkers eine regelbare Temperaturkompensationsschaltung aufweist, welche ausgebildet ist, auf Basis eines Datenempfangs von Kompensationswerten von einem Mikroprozessor und/oder aus einem Speichermedium in Abhängigkeit von der ermittelten Temperatur, das Schwingungsverhalten des Oszillators zu beeinflussen, insbesondere Temperatureinflüsse zu kompensieren und Hysterese zu unterbinden. Von der Erfindung ist weiterhin ein Verfahren zum Betrieb eines Näherungsschalters mit einer Temperaturkompensation umfasst.

## Beschreibung

Die vorliegende Erfindung betrifft einen Näherungsschalter nach dem Oberbegriff des Anspruchs 1 und ein Verfahren zum Betrieb eines Näherungsschalters nach dem Oberbegriff des Anspruchs 9.

Im Stand der Technik sind Näherungsschalter, insbesondere induktive Näherungsschalter umfassend bekannt.

Im Stand der Technik sind induktive Näherungsschalter bekannt, so beschreibt beispielsweise die DE 44 29 314 B4 einen solchen Näherungsschalter, bei dem ein magnetisches Wechselfeld in einer Spule erzeugt wird, so dass ein eindringender metallischer Gegenstand den Schwingungszustand beeinflusst. Die erfasste Änderung des Schwingungszustandes wird mit einer Schaltung ausgewertet, wobei im Wechselfeld zwei Sensorspulen in unmittelbarer Differenzschaltung zur Erfassung der induzierten Spannungen angeordnet sind. Die Differenzspannung der Sensorspulen wird dabei im Ansprechabstand zu Null. Bei der Lösung nach DE 44 29 314 B4 sind die gewickelten Spulen in drei Ebenen beziehungsweise in drei Korridoren angeordnet. Nachteilig an dieser Lösung ist, dass bei den gewickelten Spulen eine Neigung zur Alterung besteht, so dass der Schaltabstand im Laufe der Zeit driftet. Insbesondere ist der erreichbare maximale Schaltabstand mit gewickelten Spulen stark begrenzt. Eine alternative Ausführungsform zeigt die DE 10 2006 053 023 A1. An diesen bekannten Lösungen ist nachteilig, dass Temperatureinflüsse zu einer Drift oder Hysterese führen.

Zur Kompensation der Temperatureinflüsse schlägt daher die US 8,432,169 B2 vor, eine Stromspiegelschaltung mit einer Gleichgewichts-Einstellung über einen Trimmer vorzusehen, wobei Temperatureinflüsse nachlaufend auf einer datenbasierten Korrektur beachtet und korrigiert werden. Diese Temperaturkompensation ist sehr fehleranfällig und somit bei sensiblen Erfassungssituationen oder sehr großen Temperaturschwankungen nachteilig.

Weiterhin ist aus der DE 10 2005 001692 A1 bekannt, ein steuerbares Netzwerk zu verwendet und eine Übertragungsfunktion des steuerbaren Netzwerks mittels eines Steilheitsverstärkers zu steuern und die Übertragungsfunktion des steuerbaren Netzwerks in Abhängigkeit von der gemessenen Temperatur durch Verstärkungsvariation am Steilheitsverstärker zu steuern, so dass temperaturbedingte Variationen des Oszillators wenigstens teilweise kompensiert werden. Vorgeschlagen wird, als Steilheitsverstärker einen steuerbarer Differenzverstärker zu verwenden. Die Lösungen ist baulich sehr aufwändig.

Es ist die Aufgabe der vorliegenden Erfindung einen verbesserten Näherungsschalter und ein zugehöriges Verfahren vorzuschlagen, womit die Erfassungscharakteristik eines Näherungsschalters bei Temperatureinflüsse verbessert wird.

Diese Aufgabe wird erfindungsgemäß gelöst durch einen Näherungssensor nach den Merkmalen des Anspruchs 1 und einem Verfahren nach den Merkmalen des Anspruches 9. Vorteilhafte Ausgestaltungen sind in den jeweiligen, zugehörigen Unteransprüchen angegeben.

Danach wird die Aufgabe gelöst durch einen Näherungsschalter, der insbesondere als induktiver Näherungsschalter ausgebildet ist, mit einem definierten Erfassungsbereich. Der Näherungsschalter umfasst
- einen Oszillator, welcher insbesondere selbstangeregt ein magnetisches Wechselfeld erzeugt und durch ein in den Erfassungsbereich eindringendes Target seinen Schwingungszustand ändert,
- mindestens einen Oszillatorverstärker,
- mindestens einen Temperatursensor zur Erfassung der Temperatur eines Elements des Näherungsschalters, wie eine Oberflächentemperatur und/oder der Umgebungstemperatur vorgesehen ist, insbesondere zur Erfassung der Temperatur des Oszillatorverstärkers und/oder einer Spule, wobei der Oszillationsverstärker steuer- und regelbar ausgebildeten ist und mindestens eine Verstärkerstufe, idealerweise zwei Verstärkerstufen, aufweist.

Hierbei sind unter Spule die Sendespule und/oder mindestens eine Empfängerspule des Oszillators zu verstehen.

Hierbei ist der Oszillator auf Grundlage der vom dem Temperatursensor bestimmten Temperatur steuer- und/oder regelbar, so dass temperaturbedingte Einflüsse und Variationen der Oszillator-Eigenschaften zumindest teilweise oder vollständig kompensierbar sind. Weiterhin ist ein mit einem Speichermedium verbundener Mikroprozessor zum Steuern der Verstärkung des Oszillatorverstärkers umfasst. Auf dem Speichermedium sind Kompensationsdaten gespeichert oder speicherbar und vom Mikroprozessor datentechnisch erfassbar und verarbeitbar.

Hierbei meinen Kompensationsdaten oder Kompensationswerte, jegliche temperaturabhängige (digitale oder analoge) Kompensations- und Korrekturwerte, Kennlinien, Algorithmen und/oder Abhängigkeitsdaten, die einen funktionalen Zusammenhang zwischen dem Näherungssensor, dem Oszillator, einzelnen Spulen oder Komponenten des Oszillators in Abhängigkeit von der Temperatur sowie zugehörige Steuerungsdaten zur Kompensation beschreiben. Die Kompensationsdaten können laborseitig oder im laufenden Betrieb des Näherungssensors ermittelt und/oder ergänzt werden.

Hierin werden die Begriffe "Kompensationsdaten", "Kompensationswerte" und/oder "Steuerdaten" gelegentlich synonym verwendet.

Die Spannungs- und/oder Datenübertragung kann auf den bekannten Systemen wie Ethernet, Single-Pair-Ethernet (SPE), IO-Link, PoDL oder jedem sonstigen, geeigneten Kommunikationstechnologie und/oder -protokoll erfolgen.

Zur temperaturabhängigen Steuerung und/oder Regelung weist vorliegend mindestens eine Verstärkerstufe des Oszillationsverstärkers eine regelbare Temperaturkompensationsschaltung auf, welche ausgebildet ist, auf Basis eines Datenempfangs (Kompensationswert) vom Mikroprozessor und/oder aus dem Speichermedium und der in Abhängigkeit der vom Temperatursensor ermittelten Temperatur, das Schwingungsverhalten des Oszillators zu beeinflussen, insbesondere Temperatureinflüsse zu kompensieren und Hysterese zu unterbinden.

Entscheidend ist hierbei, dass der Oszillator über die Steuerung des Oszillationsverstärkers unmittelbar in seinem Schwingungsverhalten beeinflusst wird, in dem insbesondere eine gesteuerte Stromgegenkopplung erfolgt.

Die Verstärkerstufen weisen geeignete Widerstände zur Einstellung des Arbeitspunktes sowie mindestens einen Widerstand zur Stromgegenkopplung auf, für die thermische Arbeitspunktstabilisierung der Verstärkerstufe. Dieser Widerstand hat insbesondere Einfluss auf den Stromfluss durch den Transistor und hierdurch auch Einfluss auf die Amplitude des Messsignals. Die temperaturabhängige Kompensation der Schaltungskomponenten erfolgt über den Emitterzweig über eine gezielte Anpassung und Steuerung des massebezogenen Widerstandes.

Bei einer verbesserten Ausführungsvariante ist die Temperaturkompensationsschaltung in einem Emitterzweig der mindestens einen Verstärkerstufe angeordnet ist.

Vorteilhafterweise weist der Oszillationsverstärker zwei Verstärkerstufen auf, wobei in mindestens einer die Temperaturkompensationsschaltung eingebunden ist. Hierbei meint Emitterzweig der Verstärkerstufe insbesondere, dass nachfolgend kein weiterer Stromabzweig, Schaltung und/oder funktionales Element vor der Erdung oder Erdungsleitung vorgesehen ist.

Bei einer vorteilhaften Ausführungsform weist der Oszillationsverstärker zwei Verstärkerstufen auf, wobei die Temperaturkompensationsschaltung in der ersten Verstärkerstufe eingebunden ist.

Die beiden Verstärkerstufen sind vorteilhafterweise vorgesehen, um eine möglichst hohe Gesamtverstärkung erreichen zu können sowie die Phasenlage des Oszillators so zu beeinflussen, dass dieser anschwingen kann, weil jede der Transistorstufen eine Phasendrehung um 180° bewirkt.

Dabei meint erste Verstärkerstufe diejenige Verstärkerstufe, in der durch den Transistor die Phasenlage die erste Drehung um 180° erfährt und die die zweite Verstärkerstufe meint diejenige Verstärkerstufe, in welcher die Phasenlage eine weitere Drehung um 180° erfährt, so dass die Phase im Anschluss hieran um 360° bezogen auf die Ausgangslage gedreht wurde.

Eine weitere Verbesserung kann darin bestehen, dass der Oszillationsverstärker zwei Verstärkerstufen aufweist, wobei jeweils eine Temperaturkompensationsschaltung in der ersten Verstärkerstufe und zweiten Verstärkerstufe eingebunden ist. Diese beiden
Temperaturkompensationsschaltungen können baulich unterschiedlich oder auch identisch ausgebildet sein und sind idealerweise aktivierbar und deaktivierbar. Wenn die Temperaturkompensationsschaltungen baulich unterschiedlich ausgebildet sind, ist es vorteilhaft, wenn diese abhängig von dem erfassten Temperaturbereich aktiviert oder deaktiviert werden.

Beispielsweise kann eine Temperaturkompensationsschaltung ausgebildet sein, um sensibler (schneller, genauer) in einem tiefen Temperaturbereich zu arbeiten, so dass diese in dem entsprechenden Temperaturbereich aktiviert wird. Die andere Temperaturkompensationsschaltung ist analog für einen hohen oder höheren Temperaturbereich ausgebildet und wird bedarfsweise hierfür aktiviert.

Für normale Industrieanwendungen ist die Einbindung in der ersten Verstärkerstufe ausreichend. Für den Einsatz des Näherungsschalters in einem breiteren Temperaturbereich von beispielsweise - 40 bis 100°C kann zur besseren Regelung eine 2. Temperaturkompensationsschaltung vorgesehen werden, z.B. für Sensoren in der Lebensmittelindustrie oder Anwendungen, die starken Temperaturschwankungen unterliegen.

Der Temperatursensor ist beispielsweise ein Kontaktsensor, der auf oder an der Oberfläche des Oszillationsverstärkers und/oder mindestens einer Verstärkerstufe befestigt ist. Der Temperatursensor ist idealerweise ein Halbleitersensor bzw. eine Anordnung von einer oder mehreren Dioden oder auch ein temperaturabhängiger Widerstand. Im Normalfall ist dieser Sensor zwischen Spule und Oszillatorverstärker platziert, um deren Temperatur zu erfassen.

Bei einer weiteren alternativen Ausführungsform umfasst die Temperaturkompensationsschaltung einen Digitalpotentiometer und/oder besteht im Wesentlichen hieraus, der insbesondere als ein regelbarer Widerstand ausgebildet ist und ist insbesondere dazu ausgebildet, digitale Steuerbefehle vom Mikrokontroller zu empfangen. Hierbei kann die Temperaturkompensationsschaltung auf dem Spannungszweig einen Abzweig gegen Erde aufweisen, in dem ein Widerstand angeordnet ist. Dieser Abzweig auf der Spannungsseite des Digitalpotentiometers stabilisiert das Digitalpotentiometer.

Der zum Digitalpotentiometer parallel geschaltete Widerstand dient dazu, den Änderungsbereich der Temperaturkompensationsschaltung anpassen zu können. Weiterhin besteht dadurch die Möglichkeit, die Änderung des Kompensationswertes sensibler zu gestalten.

Bei einer zweiten alternativen Ausführungsform des Näherungsschalters weist die Temperaturkompensationsschaltung einen Operationsverstärker auf, der insbesondere ein Spannungsfolger ist, der auch zur Entkopplung des Mikroprozessors gegenüber dem Oszillationsverstärker dient. Die Temperaturkompensationsschaltung ist hierbei ausgebildet, um als Kompensationswert eine Puls-Weitenmodulation (PWM) zu erhalten. Als Verbesserung kann in der Steuerleitung, dem RC-Pfad zum Operationsverstärker, ein Widerstand und/oder ein gegen Erde geschalteter, abzweigender Leitungszweig vorgesehen sein, in dem weiterhin ein Kondensator angeordnet ist.
Die PWM-Auflösung stellt ein Maß für die Sensibilität der Regelung dar und kann vorteilhafterweise im Bereich einer Auflösung von 8bit bis 32bit liegen. Zudem kann vorteilhafterweise ein Tiefpassfilter vorgesehen werden, aus beispielsweise einem Kondensator und einem Widerstand, welcher das PWM-Signal in eine äquivalente Gleichspannung umwandelt.

Bei einer dritten alternativen Ausführungsform des Näherungsschalters weist die Temperaturkompensationsschaltung einen Operationsverstärker auf, wobei die Temperaturkompensationsschaltung ausgebildet ist, als Kompensationswerte einen Analogwert zu empfangen und zu verarbeiten. Vorteilhafterweise kann in der Steuerleitung, dem Pfad zum Operationsverstärker, ein Digital-/Analogwandler angeordnet sein. Der Operationsverstärker fungiert als Spannungsfolger und zur Entkopplung des Mikroprozessors gegenüber dem Oszillationsverstärkers.

Dabei bestimmt die Quantisierung des Digital-Analogumsetzers die Sensibilität der Temperaturregelung, wobei 8bit bis 32bit in der Regel ausreichend sind.

Von der Erfindung ist auch ein Verfahren zum Betrieb eines Näherungsschalters, insbesondere einem induktiven Näherungsschalter mit einem Oszillator umfasst, zur Erfassung eines Targets, wobei der Oszillator mindestens einen Oszillatorverstärker enthält. Hierbei wird
- durch den Oszillator ein magnetisches Wechselfeld erzeugt, welches durch ein in den dessen Erfassungsbereich eindringendes Target seinen Schwingungszustand ändert,
- mindestens zeitweise mittels mindestens eines Temperatursensors die Temperatur eines Elementes des Näherungssensors und/oder die Umgebungstemperatur erfasst wird,
- die Messwerte und/oder hieraus abgeleitete Daten des Temperatursensors an einen Mikroprozessor und/oder ein hiermit verbundenes Speichermedium gesendet werden, wobei auf dem Speichermedium Temperaturalgorithmen und/oder Temperaturabhängigkeitsdaten gespeichert sind. Hierbei wird auf Grundlage der vom mindestens einen Temperaturfühler bestimmten Temperatur und den auf dem Speichermedium gespeicherten Temperaturalgorithmen und/oder Temperaturabhängigkeitsdaten, vom Mikroprozessor Steuerdaten ermittelt und an mindestens eine Temperaturkompensationsschaltung des Oszillationsverstärkers gesendet, so dass temperaturbedingte Einflüsse auf das Verhalten des Oszillators zumindest teilweise kompensiert werden, idealerweise vollständig kompensiert werden.

Bei einem verbesserten Verfahren ist der Näherungsschalter nach einem der vorgenannten Ausführungsformen ausgebildet.

Eine weitere Verbesserung des Verfahrens besteht darin, dass der Temperatursensor die Temperatur der Spule und des Oszillationsverstärkers beziehungsweise mindestens einer Verstärkerstufe des Oszillationsverstärkers erfasst, wobei mit ""Spule" die Sendespule und/oder mindestens eine Empfängerspule des Oszillators gemeint ist, deren einzelne oder gemeinsame Temperatur erfasst wird.

Das Verfahren kann zusätzlich verbessert werden, wenn der Mikroprozessor die Steuerdaten an die Temperaturkompensationsschaltung des Operationsverstärkers und/oder der mindestens einen Verstärkerstufe sendet, dessen oder deren Temperatur durch den Temperatursensor erfasst wurde.

Weitere Einzelheiten und Vorteile der Erfindung sollen nun anhand eines in den Zeichnungen dargestellten Ausführungsbeispiels näher erläutert werden.

### Es zeigen:

- Fig. 1: den erfindungsgemäßen Näherungsschalter in einem zugehörigen Schaltplan,
- Fig. 2: einen Ausschnitt des Schaltplans gemäß Fig. 1 für eine alternative Ausführungsform des Näherungsschalters,
- Fig. 3: eine erste Ausführungsform einer Temperaturkompensationsschaltung,
- Fig. 4: eine zweite Ausführungsform einer Temperaturkompensationsschaltung als Verbesserung zur Ausführung nach Fig. 3,
- Fig. 5: eine dritte Ausführungsform einer Temperaturkompensationsschaltung und
- Fig. 6: eine vierte Ausführungsform einer Temperaturkompensationsschaltung.

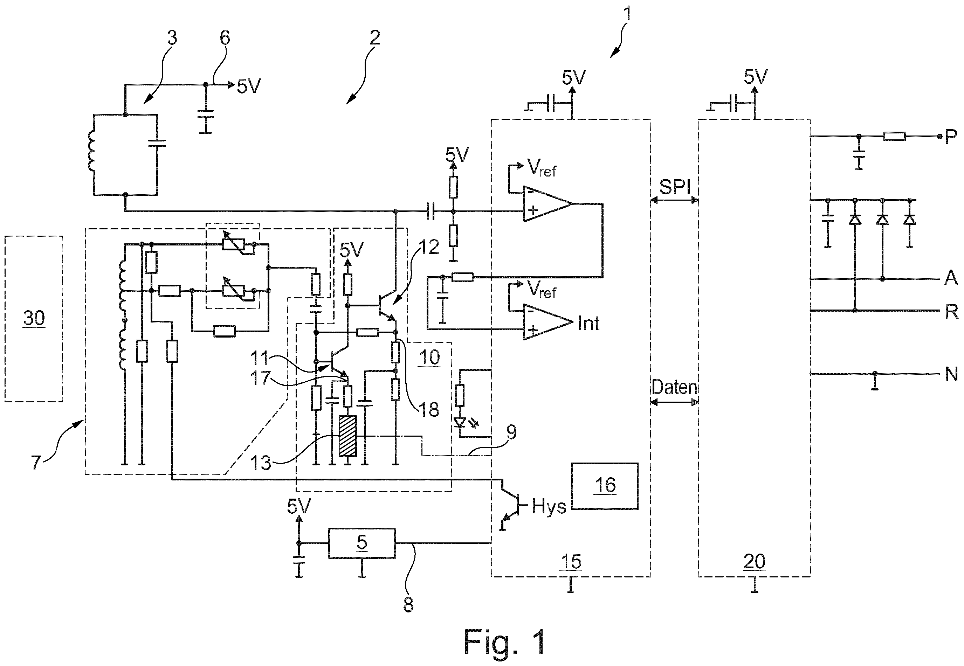

Fig. 1 zeigt eine Verschaltung oder Schaltplan für den erfindungsgemäßen Näherungsschalter 1. Der Oszillator 2 beziehungsweise die Sendespule 3 sind über die Leitung 6 mit einer Spannungsquelle über die Leitung 6 verbunden. Die Sendespule 3 wirkt in bekannter Weise mit vorliegend Empfangsspulen 7 zusammen. Deren Aufbau und Wirkweise soll vorliegend nicht weiter ausgeführt werden, insbesondere nicht die üblichen elektronischen Elemente zum Schaltabstandsabgleich.

Der Oszillator 2 umfasst einen Oszillationsverstärker 10, der eine erste Verstärkerstufe 11 und eine zweite Verstärkerstufe 12 umfasst. Die Verschaltung des Näherungsschalters 1 weist weiterhin einen schematisch dargestellten Mikroprozessor 15, der mit einem Ausgangstreiber 20 mindestens datenleitend verbunden ist, vorzugswiese über eine strommodulierte Leitung daten- und strom leitend verbunden ist.

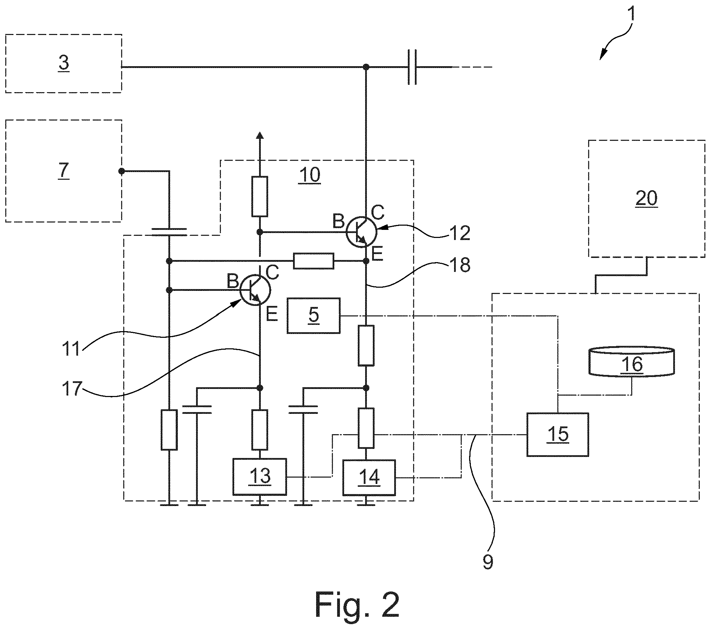

Im Emitterzweig 17 der ersten Verstärkerstufe 11 ist eine Temperaturkompensationsschaltung 13 vorgesehen, die in den nachstehenden Figuren 2 bis 6 näher beschrieben wird. Der Emitterzweig 18 der zweiten Verstärkerstufe 12 ist ohne eine Temperaturkompensationsschaltung ausgebildet. Die sonstigen (mikro-)elektronischen Bauteile sind nach dem jeweiligen Symbol zu erkennen und nicht näher beschrieben.

Im unteren Bereich der Figur 1 ist weiterhin ein Temperatursensor 5 dargestellt, der über die Leitung 8 mit dem Mikroprozessor 15 verbunden ist und weiterhin eigenständig mit einer Spannungsquelle verbunden ist. Die vom Temperatursensor 5 erhaltenen Messwerte, werden im Mikroprozessor 15 erfasst, ausgewertet und mit den in Speichermedium 16 hinterlegten Kompensationswerten, Temperaturalgorithmen und/oder Temperaturabhängigkeitsdaten abgeglichen. Der Mikroprozessor 15 sendet dann Steuerdaten über die Steuerleitung 9 an die Temperaturkompensationsschaltung 13.

Bei der Ausführungsform nach Figur 2 ist die Schaltung nach Fig. 1 vereinfacht dargestellt und identische Bezugszeichen haben dieselbe Bedeutung und werden daher teilweise nicht erneut genannt und/oder erklärt. Der Oszillationsverstärke 10 weist in dem gezeigten Beispiel in der ersten Verstärkerstufen 11 die Temperaturkompensationsschaltung 13 auf. Zusätzlich ist auch in der zweiten Verstärkerstufe 12 eine Temperaturkompensationsschaltung 14 im Emitterzweig der zweiten Verstärkerstufe 12 angeordnet.

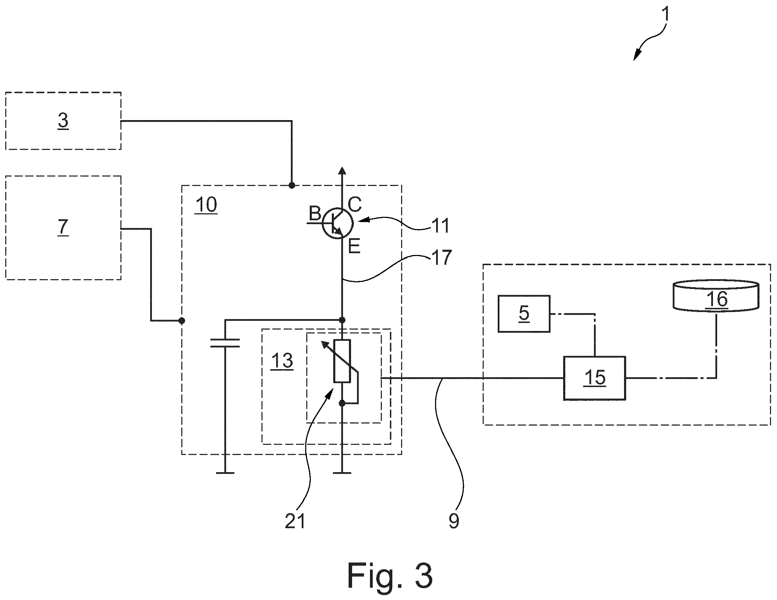

Diese Temperaturkompensationsschaltungen 13, 14 sind vorliegend baugleich und nach einer Ausführungsformen gemäß den Fig. 3 bis 6 ausgebildet. Beide Temperaturkompensationsschaltungen 13, 14 erhalten von dem Mikroprozessor 15 beziehungsweise aus dem Speichermedium 16 die Steuerdaten zur Kompensation der Temperatureinflüsse. Die Steuerdaten werden über die Steuerleitungen 9 den beiden Temperaturkompensationsschaltungen 13, 14 zugeleitet.

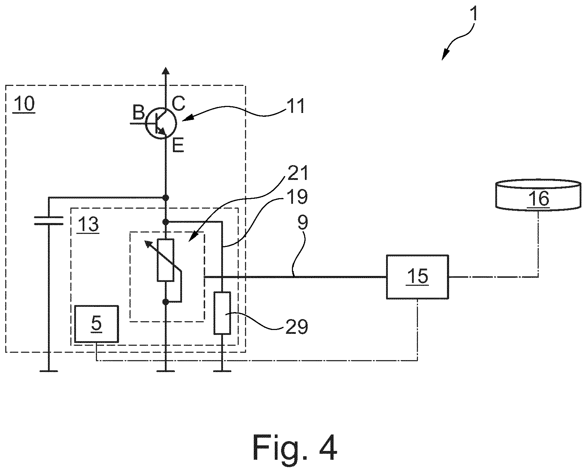

Bei dem Ausführungsbeispiel nach Figur 3 und in den weiteren Figuren 4 bis 6 ist jeweils nur noch die erste Verstärkerstufe 11 und die in dem Emitterzweig 17 angeordnete Temperaturkompensationsschaltung 13, wobei vergleichbare oder identische Elemente und/oder Schaltungen der Temperaturkompensationsschaltung auch jeweils in der zweiten Verstärkerstufe 12 und/oder in beiden Emitterzweigen 17, 18 vorgesehen werden können. Gegenüber den Figuren 1 und 2 ist die Schaltung weiter stark vereinfacht dargestellt. Die in der Figur 3 gezeigte erste Ausführungsform der Temperaturkompensationsschaltung 13 ist als Digitalpotentiometer 21 ausgebildet. Hierbei bildet beispielweise ein stufenlos steuerbarer Widerstand (Rheostat) und/oder ein anderes schaltbares mikroelektronisches Bauteil das Kernstück.

In der zweiten Ausführungsform der Temperaturkompensationsschaltung 13 nach Figur 4 ist analog zur Figur 3 ein Digitalpotentiometer 21 vorgesehen, wobei zusätzlich ein hierzu paralleler, geerdeter Leitungszweig 19 mit einem Widerstand 29 zur Empfindlichkeitsanpassung des Digitalpotentiometer 21 angeordnet ist.

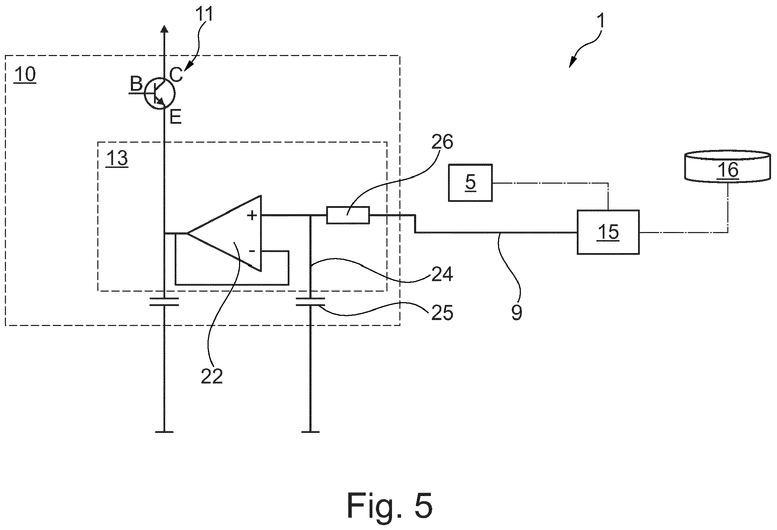

Figur 5 zeigt eine dritte Ausführungsform der Temperaturkompensationsschaltung 13, bei der ein Operationsverstärker 22 als Spannungsfolger und zur Entkopplung des Mikroprozessors 15 gegenüber dem Oszillatorverstärker 10 umfasst ist. Der Operationsverstärker 22 ist hierbei ausgebildet, als Steuerdaten und/oder Kompensationswerte eine Puls-Weitenmodulation (PWM-Wert) über die Steuerleitung 9, den RC-Pfad, zu erhalten. Zur Dämpfung und Signalglättung kann, wie auch in dem Beispiel nach Figur 5 gezeigt, in der Steuerleitung 9 ein Widerstand 26 und zwischen dem Widerstand 9 und dem Operationsverstärker 22 ein Leitungsabzweig 24 angeordnet sein, in dem ein Kondensator 25 angeordnet ist. Der Kondensator 25 bildet gemeinsam mit dem Widerstand 26 einen Tiefpassfilter, welcher das PWM-Signal in eine äquivalente Gleichspannung umwandelt.

Die PWM-Auflösung stellt ein Maß für die Sensibilität der Regelung dar und liegt im gezeigten Beispiel bei einer 12bit Auflösung.

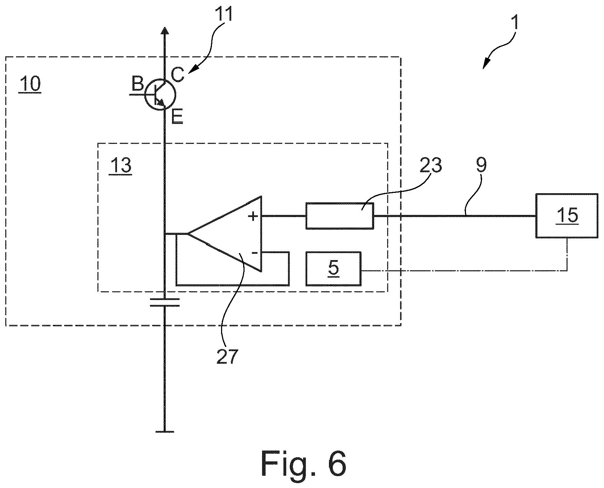

Schließlich zeigt Figur 6 die vierte Ausführungsform der Temperaturkompensationsschaltung 13, bei welcher analog zur Ausführungsform nach Figur 5 ein Operationsverstärker 27 als Spannungsfolger und zur Entkopplung des Mikroprozessors 15 gegenüber dem Oszillatorverstärker 10 vorgesehen ist. Dieser ist ausgebildet als Steuerdaten beziehungsweises Kompensationswerte Analogwerte zu empfangen und zu verarbeiten. In dem gezeigten Beispiel werden durch den Mikroprozessor 15 digitale Steuerdaten über die Steuerleitung 9, dem RC-Pfad, an den Operationsverstärker 27 gesendet, so dass in der Steuerleitung 9 ein Digital-/Analogwandler 23 angeordnet ist. Der Digital-/Analogwandler 23 kann auch dem Mikroprozessor 15 vorgeordnet sein oder in unabhängiger Weise mit dem Speichermedium zusammenwirken und die Speicherdaten in geeigneter Weise für den Mikroprozessor 15 und/oder den Operationsverstärker 27 aufbereiten.
Bei dieser Ausführungsvariante bestimmt die Quantisierung des Digital-Analogumsetzers die Feinfühligkeit der Temperaturregelung, wobei auch in diesem Beispiel eine 12bit Auflösung vorgenommen wurde. Vorteil der Verwendung eines Digital-Analogumsetzers ist, dass er in vielen Mikroprozessoren bereits enthalten ist. Weiterhin wird im Vergleich zur in Figur 5 gezeigten Variante kein Tiefpassfilter benötigt, was den Aufwand an Bauelementen reduziert.

Es ist für den Fachmann unmittelbar ersichtlich, dass die vorstehenden Ausführungsformen als Gegenstände unabhängig beschrieben wurden, aber in Teile bedarfsabhängig kombiniert werden können.

### Bezugszeichenliste

- 1: Näherungsschalter
- 2: Oszillator
- 3: Sendespule
- 4: ...
- 5: Temperatursensor
- 6: Leitung
- 7: Empfangsspulen
- 8: Leitung
- 9: Steuerleitung, RC-Pfad
- 10: Oszillatorverstärker
- 11: Verstärkerstufe
- 12: Verstärkerstufe
- 13: Temperaturkompensationsschaltung (TKS)
- 14: Temperaturkompensationsschaltung (TKS)
- 15: Mikroprozessor
- 16: Speichermedium
- 17: Emitterzweig
- 18: Emitterzweig
- 19: Leitungszweig
- 20: Ausgangstreiber
- 21: Digitalpotentiometer
- 22: Operationsverstärker (OPV)
- 23: Digital-Analogkonverter (DAC)
- 24: Leitungszweig
- 25: Kondensator
- 26: Widerstand
- 27: Operationsverstärker (OPV)
- 28: ...
- 29: Widerstand
- 30: Erfassungsbereich

## Patentansprüche

1. Näherungsschalter (1), insbesondere induktiver Näherungsschalter, mit einem definierten Erfassungsbereich (30), umfassend
- einen Oszillator (2), der ein magnetisches Wechselfeld erzeugt und durch ein in den Erfassungsbereich (30) eindringendes Target seinen Schwingungszustand ändert,
- mindestens einen Oszillatorverstärker (10),
- mindestens einen Temperatursensor (5) zur Erfassung der Temperatur eines Elements des Näherungsschalters (1) und/oder der Umgebungstemperatur vorgesehen ist, insbesondere zur Erfassung der Temperatur des Oszillatorverstärkers (10) und/oder einer Spule, wobei
der Oszillationsverstärker (10) steuer- und regelbar ausgebildeten ist und mindestens eine Verstärkerstufe (11), idealerweise zwei Verstärkerstufen (11, 12), aufweist, wobei
der Oszillator (2) auf Grundlage der vom dem Temperatursensor (5) bestimmten Temperatur steuerbar ist,
- mindestens einen Mikroprozessor (15) zum Steuern der Verstärkung des Oszillatorverstärkers (10),
- mindestens ein Speichermedium (16), welches mit dem Mikroprozessor mindestens datenleitend verbunden ist, insbesondere strom- und datenleitend verbunden ist, wobei auf dem Speichermedium (16) Kompensationsdaten gespeichert oder speicherbar sind, **dadurch gekennzeichnet, dass** die mindestens eine Verstärkerstufe (11) des Oszillationsverstärkers (10) eine regelbare Temperaturkompensationsschaltung (TKS) (13) aufweist, welche ausgebildet ist, auf Basis von Kompensationswerten als Steuerdaten vom Mikroprozessor (15) und/oder aus dem Speichermedium (16) in Abhängigkeit der vom Temperatursensor (5) ermittelten Temperatur, das Schwingungsverhalten des Oszillators (2) zu beeinflussen.

2. Näherungsschalter (1) nach Anspruch 1, **dadurch gekennzeichnet, dass** in einem Emitterzweig (13) der mindestens einen Verstärkerstufe (11, 12) eine Temperaturkompensationsschaltung (13) angeordnet ist.

3. Näherungsschalter nach Anspruch 1 oder 2, **dadurch gekennzeichnet, dass** der Oszillatorverstärker (10) zwei Verstärkerstufen (11, 12) aufweist.

4. Näherungsschalter (1) nach Anspruch 3, **dadurch gekennzeichnet, dass** der Oszillatorverstärker (10) zwei Verstärkerstufen (11, 12) aufweist, wobei die Temperaturkompensationsschaltung in der ersten Verstärkerstufe (11) eingebunden ist.

5. Näherungsschalter (1) nach einem der Ansprüche 3 oder 4, **dadurch gekennzeichnet, dass** der Oszillatorverstärker (10) zwei Verstärkerstufen aufweist, wobei jeweils eine Temperaturkompensationsschaltung (13, 14) in der ersten Verstärkerstufe (11) und zweiten Verstärkerstufe (12) eingebunden ist.

6. Näherungsschalter (1) nach einem der vorherigen Ansprüche, **dadurch gekennzeichnet, dass** die mindestens eine Temperaturkompensationsschaltung (13, 14) einen Digitalpotentiometer (30) umfasst.

7. Näherungsschalter (1) nach einem der Ansprüche 1 bis 5, **dadurch gekennzeichnet, dass** die mindestens eine Temperaturkompensationsschaltung (13, 14) einen Operationsverstärker (10) als Spannungsfolger und zur Entkopplung des Mikroprozessors (15) gegenüber dem Oszillatorverstärker (10) umfasst, wobei dieser ausgebildet ist, als Kompensationswerte eine Puls-Weitenmodulation (PWM) zur erhalten, wobei insbesondere in der Steuerleitung 9, dem RC-Pfad zum Operationsverstärker (22) ein Widerstand (26) und/oder ein Leitungszweig (24) mit einem Kondensator (25) angeordnet ist.

8. Näherungsschalter (1) nach einem der Ansprüche 1 bis 5, **dadurch gekennzeichnet, dass** die mindestens eine Temperaturkompensationsschaltung (13, 14) einen Operationsverstärker (27) als Spannungsfolger und zur Entkopplung des Mikroprozessors (15) gegenüber dem Oszillatorverstärker (10) umfasst, wobei dieser ausgebildet ist, als Kompensationswerte einen Analogwerte zu empfangen und zu verarbeiten, wobei insbesondere ein Digital-/Analogwandler (23) in der Steuerleitung 9 zum Operationsverstärker (27) angeordnet ist.

9. Verfahren zum Betrieb eines einen Oszillator (2) und mindestens einen Oszillatorverstärker (10) umfassenden Näherungsschalters (1), wobei
- durch den Oszillator (2) ein magnetisches Wechselfeld erzeugt wird, welches durch ein in den dessen Erfassungsbereich (30) eindringendes Target seinen Schwingungszustand ändert,
- mindestens zeitweise mittels mindestens eines Temperatursensors (5) die Temperatur eines Elementes des Näherungssensors (1) und/oder die Umgebungstemperatur erfasst wird,
- die Messwerte und/oder hieraus abgeleitete Daten des Temperatursensors (5) an einen Mikroprozessor (15) und/oder ein hiermit verbundenes Speichermedium (16) gesendet werden, wobei auf dem Speichermedium (16) Kompensationsdaten gespeichert sind, **dadurch gekennzeichnet, dass** auf Grundlage der vom mindestens einen Temperaturfühler (5) bestimmten Temperatur und den auf dem Speichermedium (16) gespeicherten Kompensationsdaten, der Mikroprozessor (15) Steuerdaten ermittelt und an mindestens eine Temperaturkompensationsschaltung (13, 14) des mindestens einen Oszillatorverstärkers (10) sendet, so dass temperaturbedingte Einflüsse auf das Verhalten des Oszillators (2) zumindest teilweise kompensiert werden, idealerweise vollständig kompensiert werden.

10. Verfahren nach Anspruch 9, **dadurch gekennzeichnet, dass** der Näherungsschalter (1) nach einem der Ansprüche 1 bis 8 ausgebildet ist.

11. Verfahren nach einem der Ansprüche 9 oder 10, **dadurch gekennzeichnet, dass** der Temperatursensor (5) die Temperatur des mindestens einen Oszillatorverstärker (10) erfasst, insbesondere von mindestens einer Verstärkerstufe (11, 12) erfasst.

12. Verfahren nach einem der Ansprüche 9 bis 11, **dadurch gekennzeichnet, dass** der Temperatursensor (5) die Temperatur mindestens einer Spule erfasst.

13. Verfahren nach Anspruch 11 oder 12, **dadurch gekennzeichnet, dass** der Mikroprozessor (15) die Kompensationswerte als Steuerdaten an die Temperaturkompensationsschaltung (13, 14) eines Oszillatorverstärkers (10) sendet.
